(19) Europäisches Patentamt
European Patent Office
Office européen des brevets

(11) **EP 2 154 747 B1**

(12) **EUROPEAN PATENT SPECIFICATION**

(45) Date of publication and mention
of the grant of the patent:
**03.10.2012 Bulletin 2012/40**

(51) Int Cl.:
***H05K 1/02*** *(2006.01)*        ***H01P 1/04*** *(2006.01)*

(21) Application number: **09167215.4**

(22) Date of filing: **04.08.2009**

(54) **Multilayer-structure device with vertical transition between a microstrip and a stripline**

Mehrschichtstruktur mit einem Vertikalübergang zwischen einer Mikrostreifen- und einer Streifenleitung

Structure multicouche comprenant une transition verticale entre une ligne à bande et une ligne à microbande

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **05.08.2008 IT TO20080619**

(43) Date of publication of application:
**17.02.2010 Bulletin 2010/07**

(73) Proprietor: **SELEX ELSAG S.P.A.**
**Genova (IT)**

(72) Inventors:
• **Russo, Massimo**
 **95019 Zafferana Etnea (IT)**
• **Di Maggio, Francesco**
 **90124 Palermo (IT)**
• **Pomona, Ignazio**
 **95024 Acireale (IT)**

(74) Representative: **Jorio, Paolo et al**
**Studio Torta S.p.A.**
**Via Viotti, 9**
**10121 Torino (IT)**

(56) References cited:
**EP-A1- 1 467 430**

• **BAILLARGEAT D ET AL: "High Performances of Shielded LTCC Vertical Transitions From DC up to 50 GHz" IEEE TRANSACTIONS ON MICROWAVE THEORY AND TECHNIQUES, IEEE SERVICE CENTER, PISCATAWAY, NJ, US, vol. 53, no. 6, 1 June 2005 (2005-06-01), pages 2026-2032, XP011134700 ISSN: 0018-9480**
• **JHUANG H ET AL: "Design for electrical performance of wideband multilayer LTCC microstrip-to-stripline transition" ELECTRONICS PACKAGING TECHNOLOGY CONFERENCE, 2004. EPTC 2004. PROCEEDI NGS OF 6TH SINGAPORE 8-10 DEC. 2004, PISCATAWAY, NJ, USA,IEEE, US, 8 December 2004 (2004-12-08), pages 506-509, XP010771841**

**Description**

The present invention relates to a multilayer-structure device with vertical transition between a microstrip and a stripline, in particular for high-frequency signals.

The optimisation of space in printed-circuit boards (PCBs) plays an extremely important and critical role. For this purpose, it is common to use structures with multilayer architecture comprising a plurality of substrates set on top of one another, in which electronic components and circuits are provided in the various substrates and transmission lines connect said components and circuits electrically together.

Multilayer architectures are widely used in PCBs for direct current (d.c.) applications or low-frequency applications.

Some of the conductive structures most widely used as transmission lines in multilayer architectures of this type are microstrip transmission lines and stripline transmission lines.

Microstrip transmission lines are constituted by a conductive path, for example, made of metal and of a planar type, set on a first face of a substrate of dielectric material to form a conductive strip, and by a ground plane, which is also made of metal and is set on a second face, opposite to the first, of the substrate. In this way, the substrate separates the conductive path from the ground plane. In a known way, the propagation of a signal in a microstrip transmission line occurs according to a perturbation of the fundamental TEM (Transverse Electro-Magnetic) mode, referred to as "quasi-TEM" mode.

Stripline transmission lines can be considered as microstrip transmission lines provided with a second ground plane, which is made of metal, separated from the conductive path via a second dielectric substrate, usually having a value of relative permittivity equal to that of the substrate that separates the conductive path from the other ground plane. The conductive path is hence enclosed between two ground planes and separated from these by means of respective substrates. In a known way, the propagation of a signal in a stripline transmission line occurs according to the TEM mode.

Stripline transmission lines prove advantageous as compared to microstrip transmission lines in so far as they enable a good confinement of the electromagnetic fields, but are not, however, suited for being connected with solid-state devices provided on the surface of the substrates. This type of connection, instead, can be provided by means of microstrip transmission lines.

By implementing appropriate vertical transitions to provide a connection between microstrip and stripline transmission lines, thus guaranteeing propagation of the signals, a multilayer-structure device enables the advantages of both of the transmission lines to be united.

Microstrip and/or stripline transmission lines provided in different layers of a multilayer-structure device are usually electrically connected together by means of respective via holes, made through the substrates set on top of one another.

In the last few years, the use of microstrip and stripline transmission lines in multilayer architectures for high-frequency (for example, radiofrequency) circuits has encountered considerable interest. However, when the wavelength of the signal conveyed by a transmission line is comparable to the dimensions of the transmission line itself, the concentrated-parameter analysis and design techniques used for DC or low-frequency circuits must be replaced with distributed-parameter analysis and design techniques in order to face up to the design problems due to the high frequencies used. In particular, numerous problems of dispersion, attenuation, rejection of the high-frequency signals conveyed arise at the level of the interconnections, which, as has been said, are provided by means of via holes, between transmission lines set in different layers.

Document EP 1 467 430 discloses a high frequency transmission line which is fabricated by combining different high frequency transmission lines with each other.

The aim of the present invention is to provide a multilayer-structure device with vertical transition that will be free from the drawbacks described above and in particular will optimise the coupling between a microstrip transmission line and a stripline transmission line for high-frequency signals.

According to the present invention, a multilayer-structure device with vertical transition between a microstrip and a stripline is provided as defined in Claim 1.

For a better understanding of the present invention a preferred embodiment thereof is now described, purely by way of non-limiting example and with reference to the attached drawings, wherein:

- Figure 1 shows a view in lateral cross section of a multilayer-structure device with vertical transition according to one aspect of the present invention;
- Figure 2 shows a schematic top plan view of a microstrip transmission line and of a stripline transmission line of the device of Figure 1, interconnected according to one aspect of the present invention; and
- Figure 3 is a graphic representation of the plot of the insertion loss and mismatch loss in the multilayer-structure device of Figures 1 and 2.

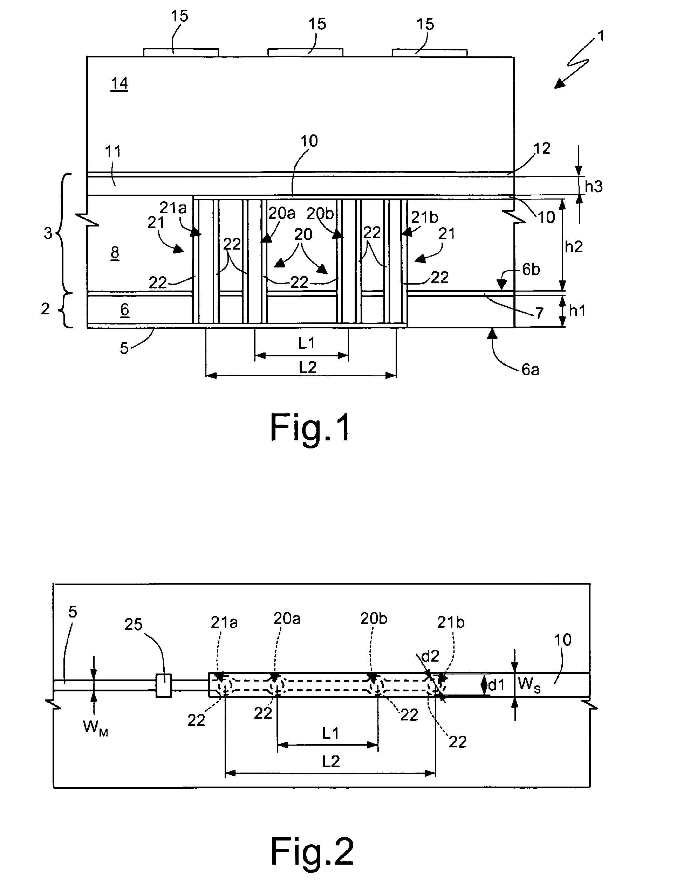

In Figure 1 designated, as a whole, by 1 is a multilayer-structure device, comprising a microstrip transmission line 2 and a stripline transmission line 3. In detail, the microstrip transmission line 2 comprises: a first conductive path 5 designed for conveying high-frequency signals, which is made of metal material, for example copper with a thickness of 18 $\mu$m and electrolytic-gold finish with a thickness of 3 $\mu$m; a first substrate 6 of dielectric material, for example a semicrystalline thermoplastic having a thickness h1 of 25 mils (0.625 mm) and dielectric constant $\varepsilon_{r1}$ of 9.9; and a first ground plane 7, made of metal material, for example copper with a thickness of 18 $\mu$m and electrolytic-gold finish with a thickness of 3 $\mu$m. The first conductive path 5 is set on a first surface 6a of the first substrate 6, accessible from the outside, and the first ground plane 7 is set on a second surface 6b, opposite to the first surface 6a of the first substrate 6 and internal to the multilayer structure.

The stripline transmission line 3 comprises: a second conductive path 10, which is made of metal material, for example copper with a thickness of 18 $\mu$m and electrolytic-gold finish with a thickness of 3 $\mu$m, and is also designed for conveying high-frequency signals; a second substrate 8, made of dielectric material with a thickness h2 of, for example, 60 mils (1.5 mm) and dielectric constant $\varepsilon_{r2}$ of 2.17; a third substrate 11, which is also made of dielectric material and has a thickness h3 of, for example, 15 mils (0,375 mm) and a dielectric constant $\varepsilon_{r3}$ of 9.9; and a second ground plane 12, which is also made of metal material, for example copper with a thickness of 18 $\mu$m and electrolytic-gold finish with a thickness of 3 $\mu$m. The stripline transmission line 3 shares moreover with the microstrip transmission line 2 the first ground plane 7. The second conductive path 10 is set between the second substrate 8 and the third substrate 11, and the second ground plane 12 is separated from the second conductive path 10 by the third substrate 11.

In particular, the multilayer-structure device 1 is referred to as of an asymmetrical type, since the second and third substrates 8, 11 have different thicknesses and dielectric constants. The asymmetrical structure, in which the third substrate 11 has a thickness smaller than the second substrate 8, enables a non-uniform distribution of the electromagnetic-field lines to be obtained and a coupling efficiency of the high-frequency signals conveyed by the second conductive path 10 that is higher towards the third substrate 11 than towards the second substrate 8.

Said effect proves advantageous in particular applications, for example in the case where, as illustrated in Figure 1, the stripline transmission line 3 is used for supplying patch antennas 15, which are set on an outer surface of a fourth substrate 14 that separates them from the second ground plane 12, in a radiofrequency (RF) circuit. In this particular application, it is necessary in fact to maximize the coupling efficiency of the stripline transmission line 3 towards the patch antennas 15.

The multilayer-structure device 1 hence favours coupling towards the third substrate 11, penalizing coupling towards the second substrate 8 and consequently towards the first conductive path 5 of the microstrip transmission line 2.

In order to maximize also the coupling between the stripline transmission line 3 and the microstrip transmission line 2, one aspect of the present invention envisages provision of a connection structure configured in such a way as to create a structure that is resonant at the operating frequency of the high-frequency signals conveyed (for example, comprised in the frequency band 7.25 GHz - 7.75 GHz, i.e., the band X of reception of the ground stations for satellite-telecommunications systems).

In detail, a first interconnection 20, comprising a first via hole 20a and a second via hole 20b, and a second interconnection 21, comprising a third via hole 21a and a fourth via hole 21b, are provided. The distances between the via holes of the first and second interconnections 20, 21 are chosen in such a way as to generate resonance conditions for signals travelling in a respective one between the microstrip transmission line 2 and the stripline transmission line 3 and having pre-set frequencies.

In fact, by means of the first and second interconnections 20, 21 (and hence the pairs of via holes 20a-20b and 21a-21b) a coupler between the first and second conductive paths 5, 10 is provided, the resonant structure of which enables maximum signal transfer to be obtained and an excellent impedance matching at the resonance frequency.

The first and second interconnections 20, 21 are provided by perforating the first and second substrates 6, 8 and the first ground plane 7 so as to set in contact the first and second conductive paths 5, 10. A coating layer 22, made of metal material, for example gold, is deposited on the internal walls of the first, second, third, and fourth via holes 20a, 20b, 21a, 21b so as to create an electrical contact between the first and second conductive paths 5, 10. It is moreover expedient not to create a direct electrical contact between the coating layer 22 internal to the via hole 20a, 20b, 21a, 21b and the first ground plane 7. For this purpose, during the process of production of the multilayer-structure device 1, it is appropriate create on the first ground plane 7 circular areas without metallization (not illustrated) through which the via holes 20a, 20b, 21a, 21b can traverse the ground plane preventing any electrical contact therewith.

Figure 2 shows a top plan view of the first and second conductive paths 5, 10 and of the via holes 20a, 20b, 21a, 21b that provide the first and second interconnections 20, 21.

The first conductive path 5 has, in top plan view, a width WM of 0.6 mm, whilst the second conductive path has, in top plan view, a width WS of 1.2 mm. The via holes 20a, 20b, 21a, 21b advantageously have a circular cross section, of a diameter d1 of, for example, 0.65 mm and a diameter d2, obtained following upon deposition of the coating layer 22 of, for example, 1.3 mm. In addition, designated by L1 is the distance between the first and second via holes 20a, 20b of the first interconnection 20, and by L2 the distance between the third and fourth via holes 21a, 21b of the second interconnection 21.

The resonance condition for the first and second conductive paths 5, 10 is obtained when between the distances L1 and L2 and the effective wavelengths $\lambda_1$, $\lambda_2$ of the microstrip transmission line 2 and stripline transmission line 3 the following relation applies:

$$L_1 = n \cdot \lambda_1 / 4 \quad \text{and} \quad L_2 = n \cdot \lambda_2 / 4$$

where n is any integer. However, for purposes of implementation and for simplicity of design, it is convenient to use a value of n equal to 1.

In particular, since the effective wavelength $\lambda_1$ of the microstrip transmission line 2 is different from the effective wavelength $\lambda_2$ of the stripline transmission line 3, the distance $L_1$ between the via holes 20a and 20b, and the distance $L_2$ between the via holes 21a and 21b have a different value.

In greater detail, in a transmission line, the effective wavelength $\lambda$ is given by the following formula (1):

$$\lambda = \frac{\lambda_0}{\sqrt{\varepsilon_{\textit{eff}}}}, \tag{1}$$

where $\varepsilon_{\textit{eff}}$ is the effective dielectric constant and depends upon the dielectric constant of the material of which the substrate is made and upon the geometrical characteristics of the transmission line, and $\lambda_0$ is the wavelength in the free space of the signal travelling on the transmission line, and is given by the formula (2)

$$\lambda_0 = \frac{c}{f}, \tag{2}$$

where c is the speed of light in a vacuum and f the operating frequency, for example, the central frequency of the band of use of the multilayer-structure device 1 (equal to 7.5 GHz in the case of the aforesaid frequency band of 7.25 GHz to 7.75 GHz). By substituting $\lambda_0$ in the formula (1), we obtain

$$\lambda = \frac{c}{f \cdot \sqrt{\varepsilon_{\textit{eff}}}}. \tag{3}$$

Consequently, the distance $L_1$ between the first and second via holes 20a and 20b to obtain resonance conditions in the microstrip transmission line 2 is given by (assuming n=1):

$$L_1 = \frac{c}{4 \cdot f \cdot \sqrt{\varepsilon_{\textit{eff}1}}} \tag{4}$$

where $\varepsilon_{\textit{eff}1}$ is the effective dielectric constant for the first substrate 6. Instead, the distance $L_2$ between the third and fourth via holes 21a and 21b to obtain resonance conditions in the stripline transmission line 3 is given by (assuming n=1)

$$L_2 = \frac{c}{4 \cdot f \cdot \sqrt{\varepsilon_{\textit{eff}2}}}. \tag{5}$$

where $\varepsilon_{\textit{eff}2}$ is the effective dielectric constant for the second substrate 8.

By imposing a pre-set value, for example, 50 Ω, for the characteristic impedance $Z_0$ of the first and second interconnections 20, 21 seen, respectively, from the first conductive path 5 and from the second conductive path 10, it is possible to size both the microstrip transmission line 2 and the stripline transmission line 3 and obtain the value of the

effective dielectric constants $\varepsilon_{\text{eff1}}$ and $\varepsilon_{\text{eff2}}$.

In a known way, the characteristic impedance $Z_0$ is a function of the dielectric constant in the medium, of the geometrical parameters of the conductive path considered ($W_M$ and h1 for the microstrip transmission line 2 and $W_S$ and h2 for the stripline transmission line 3), and of the operating frequency used.

In detail, the characteristic impedance of the microstrip transmission line 2 is given by

$$Z_0 = \begin{cases} \dfrac{60}{\sqrt{\varepsilon_{\textit{eff1}}}} \ln\left(\dfrac{8h_1}{W_M} + \dfrac{W_M}{4h_1}\right) & \text{if } W_M / h_1 \leq 1 \\ \dfrac{120\pi}{\sqrt{\varepsilon_{\textit{eff1}}}\left[W_M / h_1 + 1.393 + 0.667\ln\left(W_M / h_1 + 1.444\right)\right]} & \text{if } W_M / h_2 \geq 1 \end{cases} \qquad (6)$$

where the effective dielectric constant $\varepsilon_{\text{eff1}}$ is given by

$$\varepsilon_{\text{eff1}} = \frac{\varepsilon_{\text{r1}} + 1}{2} + \frac{\varepsilon_{\text{r1}} - 1}{2} \cdot \frac{1}{\sqrt{1 + 12h_1 / W_M}} \qquad (7)$$

where $\varepsilon_{\text{r1}}$ is the dielectric constant of the first substrate 6.

It is possible to define in a similar way the characteristic impedance of the stripline transmission line 3

$$Z_0 = \frac{30\pi}{\sqrt{\varepsilon_{\text{eff2}}}} \cdot \frac{h_2}{W_e + 0.441 \cdot h_2} \qquad (8)$$

where

$$\frac{W_e}{h_2} = \frac{W_S}{h_2} - \begin{cases} 0 & \textit{if } W_S / h_2 > 0.35 \\ \left(0.35 - W_S / h_2\right)^2 & \textit{if } W_S / h_2 < 0.35 \end{cases} \qquad (9)$$

Using Eqs. (6) - (9) it is thus possible to determine, starting from a given sizing of the microstrip and stripline transmission lines 2, 3, the values of the effective dielectric constants $\varepsilon_{\textit{eff1}}$ and $\varepsilon_{\textit{eff2}}$ and, by substituting the values of $\varepsilon_{\textit{eff1}}$ and $\varepsilon_{\textit{eff2}}$ thus calculated in Eqs. (4) and (5), it is possible to calculate the distances $L_1$ and $L_2$ to obtain resonance conditions both for the microstrip transmission line 2 and for the stripline transmission line 3.

For example, using the multilayer-structure device 1 of Figure 1, the value of the distances L1 and L2 is equal, respectively, to 3.8 mm and 7.7 mm.

From an examination of the characteristics of the multilayer-structure device provided according to the present invention, the advantages that it affords are evident.

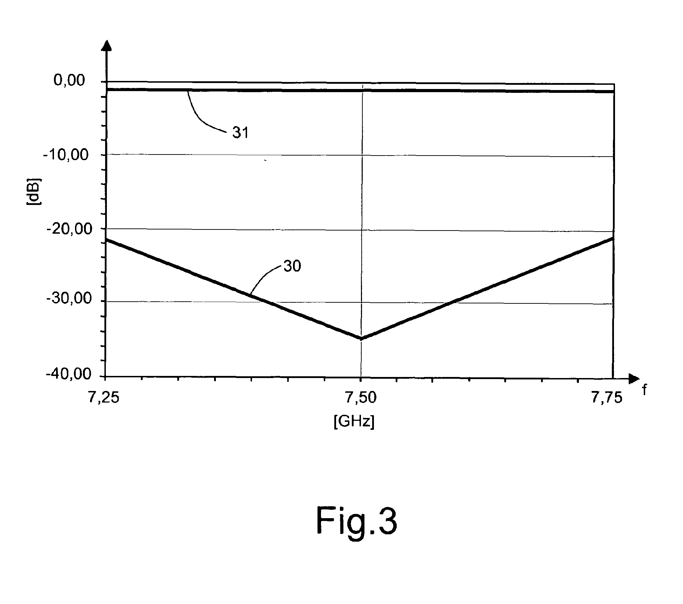

In particular, the graph in Figure 3 shows the plots of the insertion loss 30 and mismatch loss 31 of the multilayer-structure device 1 operating in the frequency band 7.25 GHz-7.75 GHz, hence with central design frequency of 7.5 GHz. As may be noted, the multilayer-structure device 1 has low mismatch losses over the entire frequency band considered, with a minimum for the central design frequency, where the mismatch losses reach a minimum of approximately -35 dB. In addition, also the insertion losses have a low value over the entire band, of approximately -1 dB.

The multilayer-structure device 1 is hence advantageous in all the cases where it is necessary to interconnect conductive paths of transmission lines set on different layers of a multilayer structure, obtaining excellent performance both in terms of insertion loss and of mismatch loss over the entire band of use, in particular for high-frequency applications.

The structure described is, for example, advantageous in radiofrequency circuits in which it is necessary to supply the radiant elements of an array of antennas and/or to collect a signal received thereby. In this case, it is necessary to supply the radiant elements by means of signals with an appropriate phase shift with respect to one another in such a way as to enable the desired orientation of the irradiated beam. Given the high number of radiofrequency lines (equal to the number of radiant elements of the antenna) it is extremely advantageous to use the multilayer structure in which the stripline transmission line is used for providing the network for feeding the antenna elements (feed line network) and recombine/divide the radiofrequency signal. In particular, it is possible to make a transition with low losses from the stripline transmission line to the microstrip transmission line (and vice versa), connected to which are the active elements (for example, low-noise amplifiers and power amplifiers) required for the operations of reception and transmission.

Finally, it is clear that modifications and variations may be made to the multilayer-structure device 1 described and illustrated herein, without thereby departing from the sphere of protection of the present invention.

In particular, in the case where the interconnection occurs between transmission lines of the same type and hence with one and the same effective wavelength $\lambda$, the resonance condition is likewise verified by using a single pair of via holes, for example, by providing exclusively the first interconnection 20.

In addition, with reference to Figure 2, it is possible to set a stub 25 on the first conductive path 5 in order to limit further the return losses at input.

The multilayer-structure device 1 can have a different number, with respect to what is illustrated in Figure 1, of substrates and transmission lines, and each substrate can moreover have a thickness different from the ones indicated.

Finally, the stripline transmission line 3 can be of a symmetrical type (i.e., with the second and third substrates 8, 11 having the same thickness and dielectric constant), and the multilayer-structure device 1 can be used for applications different from the one illustrated.

## Claims

1. Vertical transition device (1), comprising: a plurality of overlapped layers, defining a first (2) and a second (3) transmission line, said first transmission line (2) including a first conductive line (5) and said second transmission line (3) including a second conductive line (10); and an electrical connection structure (20, 21) extending vertically through one or more of said overlapped layers and forming a connection between said first conductive line (5) and said second conductive line (10), said electrical connection structure (20, 21) comprising a first and a second interconnection element (20a, 20b) connecting the first and the second conductive line (5, 10) to one another, **characterized in that** the first and second interconnection element (20a, 20b) are arranged at a first distance (L1) between each other equal to one quarter of an effective wavelength ($\lambda1$, $\lambda2$) or a multiple of one quarter of effective wavelength ($\lambda1$, $\lambda2$) of a signal flowing in said first (5) and/or second (10) conductive line.

2. Vertical transition device according to claim 1, wherein said first transmission line (2) comprises a first substrate (6) to which said first conductive line (5) is coupled, and said second transmission line (3) comprises a second substrate (8), vertically overlapped with said first substrate (6), to which said second conductive line (10) is coupled; said first and second interconnection element being via holes (20a, 20b) formed through said first and second substrate (6, 8).

3. Vertical transition device according to claim 2, wherein said first and second transmission line (2, 3) have different effective wavelengths ($\lambda1$, $\lambda2$); and moreover comprising a third and a fourth interconnection element (21a, 21b) connecting the first and the second conductive line (5, 10) to one another, the first and second interconnection element (20a, 20b) being arranged at said first distance (L1) between each other each other to generate a condition of resonance for a signal flowing in said first conductive line (5), and the third and the fourth interconnection element (21a, 21b) being arranged at a second distance (L2) between each other each other to generate a condition of resonance for a signal flowing in said second conductive line (10).

4. Vertical transition device according to claim 3, wherein said first distance (L1) is a multiple of one quarter of an effective wavelength ($\lambda1$) of said first (5) conductive line, and said second distance (L2) is one quarter of an effective wavelength ($\lambda2$) or a multiple of one quarter of an effective wavelength ($\lambda2$) of the second conductive line (10).

5. Vertical transition device according to claim 4, wherein said first transmission line (2) is a microstrip and comprises: a first substrate (6) to which said first conductive line (5) is coupled, and a first reference conductive plate (7), overlapped with said first substrate (6); and said second transmission line (3) is a stripline and comprises: a second substrate (8), vertically overlapped with said first reference conductive plate (7) and to which said second conductive line (10) is coupled, a third substrate (11) overlapped with said second conductive line (10), and a second reference conductive plate (12) overlapped with said third substrate (11); said first, second, third and fourth interconnection element being via holes (20a, 20b, 21a, 21b) formed through said first and second substrate (6, 8) and said first reference conductive plate (7).

6. Vertical transition device according to any of preceding claims, wherein said predefined frequency band comprises high frequencies, in particular radio frequencies, more in particular frequencies between 7.25 GHz and 7.75 GHz.

7. Vertical transition device according to any of the preceding claims, wherein the first transmission line (2) moreover comprises a matching stub (25) coupled to the first conductive line (5), and configured to minimize the return loss of said first conductive line (5).

8. Vertical transition device according to any of the preceding claims, wherein said second transmission line (3) is electromagnetically coupled to at least one antenna element (15).

9. Radiofrequency circuit, comprising an antenna element (15) and a vertical transition device (1) according to any of the preceding claims, electrically coupled to said antenna element (15).

**Patentansprüche**

1. Bauelement mit Vertikalübergang (1), umfassend: eine Mehrzahl von überlagerten Schichten, die eine erste (2) und eine zweite (3) Übertragungsleitung (2) bilden, wobei die erste Übertragungsleitung (2) eine erste leitfähige Leitung (5) enthält und die zweite Übertragungsleitung (3) eine zweite leitfähige Leitung (10) enthält, und eine elektrische Anschlussstruktur (20, 21), die sich vertikal durch ein oder mehrere der überlagerten Schichten hindurch erstreckt und einen Anschluss zwischen der ersten leitfähigen Leitung (5) und der zweiten leitfähigen Leitung (10) bildet, wobei die elektrische Anschlussstruktur (20, 21) ein erstes und ein zweites Zusammenschaltungselement (20a, 20b) umfasst, welche die erste und die zweite leitfähige Leitung (5, 10) miteinander verbinden, **dadurch gekennzeichnet, dass** das erste und zweite Zusammenschaltungselement (20a, 20b) in einem ersten Abstand (L1) zueinander angeordnet sind, der gleich einem Viertel einer effektiven Wellenlänge ($\lambda$1, $\lambda$2) oder einem Mehrfachen eines Viertels der effektiven Wellenlänge ($\lambda$1, $\lambda$2) eines in der ersten (5) und/oder der zweiten (10) leitfähigen Leitung fließenden Signals beträgt.

2. Bauelement mit Vertikalübergang nach Anspruch 1, in welchem die erste Übertragungsleitung (2) ein erstes Substrat (6) umfasst, an welches die erste leitfähige Leitung (5) gekoppelt ist, und die zweite Übertragungsleitung (3) ein von dem ersten Substrat (6) vertikal überlagertes zweites Substrat (8) umfasst, an welches die zweite leitfähige Leitung (10) gekoppelt ist, wobei das erste und zweite Zusammenschaltungselement über Löcher (20a, 20b) durch das erste und zweite Substrat (6, 8) hindurch gebildet sind.

3. Bauelement mit Vertikalübergang nach Anspruch 2, in welchem die erste und zweite Übertragungsleitung (2, 3) unterschiedliche effektive Wellenlängen ($\lambda$1, $\lambda$2) haben und zudem ein drittes und ein viertes Zusammenschaltungselement (21 a, 21b) umfassen, welche die erste und die zweite leitfähige Leitung (5, 10) miteinander verbinden, wobei das erste und zweite Zusammenschaltungselement (20a, 20b) in dem ersten Abstand (L1) zueinander angeordnet sind, um einen Resonanzzustand für ein in der ersten leitfähigen Leitung (5) fließendes Signal zu erzeugen, und das dritte und das vierte Zusammenschaltungselement (21 a, 21b) in einem zweiten Abstand (L2) zueinander angeordnet sind, um einen Resonanzzustand für ein in der zweiten leitfähigen Leitung (10) fließendes Signal zu erzeugen.

4. Bauelement mit Vertikalübergang nach Anspruch 3, in welchem der erste Abstand (L1) ein Mehrfaches eines Viertels einer effektiven Wellenlänge ($\lambda$1) der ersten (5) leitfähigen Leitung ist und der zweite Abstand (L2) ein Viertel einer effektiven Wellenlänge ($\lambda$2) oder ein Mehrfaches eines Viertels einer effektiven Wellenlänge ($\lambda$2) der zweiten leitfähigen Leitung (10) ist.

5. Bauelement mit Vertikalübergang nach Anspruch 4, in welchem die erste Übertragungsleitung (2) ein Mikrostreifen ist und umfasst: ein erstes Substrat (6), an welches die erste leitfähige Leitung (5) gekoppelt ist, und eine erste leitfähige Bezugsplatte (7), die von dem ersten Substrat (6) überlagert wird, und die zweite Übertragungsleitung (3) eine Streifenleitung ist und umfasst: ein zweites Substrat (8), das von der ersten leitfähigen Bezugsplatte (7) vertikal überlagert wird und an welches die zweite leitfähige Leitung (10) gekoppelt ist, ein drittes Substrat (11), das von der zweiten leitfähigen Leitung (10) überlagert wird, und eine zweite leitfähige Bezugsplatte (12), die von dem dritten Substrat (11) überlagert wird, wobei das erste, zweite, dritte und vierte Zwischenschaltungselement über Löcher (20a, 20b, 21a, 21b) durch das erste Plattensubstrat (6, 8) und die erste leitfähige Bezugsplatte (7) hindurch ausgebildet sind.

6. Bauelement mit Vertikalübergang nach einem der der vorhergehenden Ansprüche, in welchem das vordefinierte Frequenzband hohe Frequenzen umfasst, insbesondere Hochfrequenzen, ganz besonders Frequenzen zwischen 7,25 GHz und 7,75 GHz.

7. Bauelement mit Vertikalübergang nach einem der vorhergehenden Ansprüche, in welchem die erste Übertragungsleitung (2) zudem eine abgleichende Stichleitung (25) umfasst, die an die erste leitfähige Leitung (5) gekoppelt ist, und so konfiguriert ist, dass die Rückflussdämpfung der erste leitfähigen Leitung (5) minimiert wird.

8. Bauelement mit Vertikalübergang nach einem der vorhergehenden Ansprüche, in welchem die zweite Übertragungsleitung (3) elektromagnetisch an wenigstens ein Antennenelement (15) gekoppelt ist.

9. Hochfrequenzschaltkreis, mit einem Antennenelement (15) und einem Bauelement mit Vertikalübergang (1) nach einem der vorhergehenden Ansprüche, elektrisch gekoppelt an das Antennenelement (15).

**Revendications**

1. Dispositif de transition verticale (1), comprenant : une pluralité de couches chevauchées, définissant une première (2) et une seconde (3) ligne de transmission, ladite première ligne de transmission (2) incluant une première ligne conductrice (5) et ladite seconde ligne de transmission (3) incluant une seconde ligne conductrice (10) ; et une structure de connexion électrique (20, 21) s'étendant verticalement à travers une ou plusieurs desdites couches chevauchées et formant une connexion entre ladite première ligne conductrice (5) et ladite seconde ligne conductrice (10), ladite structure de connexion électrique (20, 21) comprenant un premier et un deuxième élément d'interconnexion (20a, 20b) connectant les première et seconde lignes conductrices (5, 10) l'une à l'autre, **caractérisé en ce que** le premier et le deuxième élément d'interconnexion (20a, 20b) sont agencés à une première distance (L1) l'un de l'autre égale à un quart d'une longueur d'onde effective ($\lambda 1$, $\lambda 2$) ou un multiple d'un quart de longueur d'onde effective ($\lambda 1$, $\lambda 2$) d'un signal circulant dans ladite première (5) et/ou seconde (10) ligne conductrice.

2. Dispositif de transition verticale selon la revendication 1, dans lequel ladite première ligne de transmission (2) comprend un premier substrat (6) auquel ladite première ligne conductrice (5) est couplée, et ladite seconde ligne de transmission (3) comprend un deuxième substrat (8), verticalement chevauché par ledit premier substrat (6), auquel ladite seconde ligne conductrice (10) est couplée ; lesdits premier et deuxième éléments d'interconnexion étant des trous d'interconnexion (20a, 20b) formés à travers lesdits premier et deuxième substrats (6, 8).

3. Dispositif de transition verticale selon la revendication 2, dans lequel lesdites première et seconde lignes de transmission (2, 3) ont des longueurs d'onde effectives différentes ($\lambda 1$, $\lambda 2$) ; et de plus comprenant un troisième et un quatrième élément d'interconnexion (21a, 21b) connectant la première et la seconde ligne conductrice (5, 10) l'une à l'autre, le premier et le deuxième élément d'interconnexion (20a, 20b) étant agencés à ladite première distance (L1) l'un de l'autre pour générer une condition de résonance pour un signal circulant dans ladite première ligne conductrice (5), et le troisième et le quatrième élément d'interconnexion (21a, 21b) étant agencés à une seconde distance (L2) l'un de l'autre pour générer une condition de résonance pour un signal circulant dans ladite seconde ligne conductrice (10).

4. Dispositif de transition verticale selon la revendication 3, dans lequel ladite première distance (L1) est un multiple d'un quart d'une longueur d'onde effective ($\lambda 1$) de ladite première (5) ligne conductrice et ladite seconde distance (L2) est un quart d'une longueur d'onde effective ($\lambda 2$) ou un multiple d'un quart d'une longueur d'onde effective ($\lambda 2$) de la seconde ligne conductrice (10).

5. Dispositif de transition verticale selon la revendication 4, dans lequel ladite première ligne de transmission (2) est un microruban et comprend : un premier substrat (6) auquel ladite première ligne conductrice (5) est couplée, et une première plaque conductrice de référence (7), chevauchée par ledit premier substrat (6) ; et ladite seconde ligne de transmission (3) est une ligne à ruban et comprend : un deuxième substrat (8), chevauché verticalement par ladite première plaque conductrice de référence (7) et auquel ladite seconde ligne conductrice (10) est couplée, un troisième substrat (11) chevauché par ladite seconde ligne conductrice (10), et une seconde plaque conductrice de référence (12) chevauchée par ledit troisième substrat (11) ; lesdits premier, deuxième, troisième et quatrième éléments d'interconnexion étant des trous d'interconnexion (20a, 20b, 21a, 21b) formés à travers lesdits premier et deuxième substrats (6, 8) et ladite première plaque conductrice de référence (7).

6. Dispositif de transition verticale selon l'une quelconque des revendications précédentes, dans lequel ladite bande de fréquence prédéfinie comprend des hautes fréquences, en particulier des radiofréquences, plus particulièrement des fréquences comprises entre 7,25 GHz et 7,75 GHz.

7. Dispositif de transition verticale selon l'une quelconque des revendications précédentes, dans lequel la première ligne de transmission (2) comprend en outre une souche de concordance (25) couplée à la première ligne conductrice (5), et configurée pour minimiser la perte de retour de ladite première ligne conductrice (5).

8. Dispositif de transition verticale selon l'une quelconque des revendications précédentes, dans lequel ladite seconde ligne de transmission (3) est couplée électromagnétiquement à au moins un élément d'antenne (15).

9. Circuit radiofréquence, comprenant un élément d'antenne (15) et un dispositif de transition verticale (1) selon l'une quelconque des revendications précédentes, couplé électriquement audit élément d'antenne (15).

# Fig.1

# Fig.2

Fig.3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• EP 1467430 A